# FASCICULE DE BREVET EUROPEEN

(11) **EP 3 670 709 B1**
(45) Date de publication et mention de la délivrance du brevet: **28.08.2024**
(21) Numéro de dépôt: 19216766.6
(22) Date de dépôt: 17.12.2019
(51) Int. Cl.: C30B 25/10, C30B 25/18, C30B 29/52, H01L 21/02, H01L 21/311

(54) **PROCEDE DE FABRICATION D'UNE STRUCTURE MONOCRISTALLINE**
HERSTELLUNGSVERFAHREN EINER MONOKRISTALLINEN STRUKTUR
METHOD FOR MANUFACTURING A MONOCRYSTALLINE STRUCTURE

(30) Priorité: 17.12.2018 FR 1873118
(43) Date de publication de la demande: 24.06.2020
(73) Titulaire: Commissariat à l'Energie Atomique et aux Energies Alternatives, 75015 Paris (FR); Centre National de la Recherche Scientifique, 75016 Paris (FR); Université Grenoble Alpes, 38400 Saint-Martin-d'Hères (FR)
(72) Inventeur: RAYNAL, Pierre-Edouard, 38000 Grenoble (FR); BESSON, Pascal, 38220 Notre Dame De Mesage (FR); HARTMANN, Jean-Michel, 38054 Grenoble (FR); LOUP, Virginie, 38054 Grenoble (FR); VALLIER, Laurent, 38330 Montbonnot Saint Martin (FR)
(74) Mandataire: Talbot, Alexandre

(56) Documents cités:
- US-A1- 2009 029 529
- US-A1- 2016 192 502

## Description

### Domaine technique

L'invention est relative à un procédé de fabrication d'une structure monocristalline qui comporte une étape d'épitaxie à partir d'une couche en alliage de silicium-germanium.

### Technique antérieure

Il est connu de réaliser des dispositifs semi-conducteurs en utilisant une ou plusieurs couches de silicium qui sont fonctionnalisées, par exemple, pour former un canal de conduction d'un transistor à effet de champ. Cependant, les performances du silicium ne permettent pas toujours d'atteindre les besoins électriques et/ou mécaniques attendus de sorte que de nouveaux matériaux sont utilisés pour remplacer le silicium et notamment le germanium. Il en ressort que le germanium occupe une place grandissante dans la fabrication des dispositifs microélectroniques modernes.

Il existe notamment un intérêt croissant à l'utilisation de films en alliage de silicium-germanium à la place des films en silicium pour améliorer les performances électriques des dispositifs tels des transistors à effet de champ qui pourront utiliser ces alliages en tant que canaux de conduction.

Malheureusement, les films en alliage de silicium-germanium sont plus difficiles à utiliser que les films en silicium ce qui complique les procédés de fabrication. Les films en alliage de silicium-germanium sont très souvent contraints et notamment en compression de sorte que l'application d'un budget thermique élevé peut se traduire par une déformation du film. Cette déformation peut se manifester par une ondulation du film ou par sa relaxation. Comme pour les films de silicium, les films en silicium-germanium déposés sur une couche de matériau diélectrique ont tendance à démouiller lorsque le budget thermique est trop important ce qui rend impossible le dépôt d'un film monocristallin de bonne qualité.

Il est recherché des solutions permettant de travailler plus facilement avec les films en alliage de silicium-germanium. Dans de nombreux procédés de réalisation des dispositifs microélectronique, il devient nécessaire d'épaissir ponctuellement le film en alliage de silicium-germanium ou d'une manière plus générale de réaliser une reprise d'épitaxie depuis la surface libre de la couche en alliage.

Le budget thermique accepté par l'alliage de silicium-germanium étant limité cela pose une contrainte technologique importante lorsque l'on souhaite déposer une couche cible monocristalline d'un matériau quelconque en accord de maille avec la couche monocristalline en alliage de silicium-germanium. Les conditions opératoires doivent être choisies de manière à ne pas dégrader la couche en alliage tout en déposant une couche cible de bonne qualité.

Il est classique de soumettre la couche d'alliage à un bain d'acide fluorhydrique afin de retirer l'oxyde présent à sa surface. La surface de la couche d'alliage qui a été désoxydée est ensuite rapidement introduite dans une chambre de procédé d'un bâti d'épitaxie pour subir un recuit sous hydrogène, typiquement à 650°C pendant quelques minutes afin de terminer la préparation de surface. Après le recuit sous hydrogène, une couche monocristalline est déposée sur l'alliage de silicium-germanium. Le résultat est généralement non satisfaisant.

Il est connu du document US 7,462,239 de déposer un film monocristallin sur une couche monocristalline en alliage de silicium-germanium. La couche en alliage de silicium-germanium est soumise à une étape de désoxydation au moyen d'un bain d'acide fluorhydrique. Après la désoxydation de la surface, le substrat contenant la couche en alliage est introduit dans une chambre de procédé à une température inférieure à 500°C avant de subir une rampe en température rapide sous une atmosphère d'hydrogène jusqu'à environ 700°C avant d'effectuer le dépôt épitaxial dans la gamme 450°C-950°C.

Par ailleurs, il a été montré que les surfaces en alliage de silicium-germanium sont très réactives à l'air et s'oxydent rapidement. Il résulte de cette oxydation accélérée des alliages de silicium-germanium que le technologue doit limiter autant que possible la durée pendant laquelle les surfaces des alliages de silicium-germanium sont mises à découvert. Cette problématique est particulièrement importante lorsqu'il est envisagé de nettoyer la surface du substrat avant d'effectuer un épaississement d'au moins une partie du substrat par épitaxie pour déposer un matériau monocristallin en accord de maille avec la couche monocristalline sousjacente en alliage de silicium-germanium.

Dans une approche industrielle, il n'est pas toujours aisé de limiter l'enchainement de deux étapes technologiques consécutives à des durées très faibles de l'ordre de quelques minutes. Il est donc recherché des moyens permettant de réaliser le dépôt d'une couche cible monocristalline de bonne qualité dans des conditions opératoires plus variées.

Il apparaît également que même en limitant la durée entre le traitement par l'acide fluorhydrique et le dépôt par épitaxie, la qualité des couches déposées n'est pas toujours satisfaisante. Des études ont montré que l'utilisation d'un bain d'acide fluorhydrique suivi rapidement ou non par l'étape de recuit sous hydrogène se traduit par la présence d'une pollution importante en oxygène, carbone et fluor à l'interface entre l'alliage de silicium-germanium et la couche cible déposée.

Cette pollution peut avoir un effet très négatif sur la qualité de la couche déposée et elle peut avoir également un impact sur les étapes technologiques à suivre et/ou sur les performances du dispositif final. Il existe une véritable problématique d'intégration des reprises d'épitaxie sur les films en alliage de silicium-germanium.

Il est connu du document US 2016/0192502 de retirer un oxyde sur la surface d'une couche en silicium-germanium au moyen du dépôt d'un matériau contenant un halogène sur une couche d'oxyde à base de silicium et la sublimation d'une partie du matériau contenant l'halogène pour exposer le silicium à la surface. Un film de passivation comportant un chlorure est déposé sur le silicium exposé pour éviter la contamination de la surface en silicium. Le film de passivation est ensuite sublimé avant de déposer un matériau cible sur le substrat.

### Objet de l'invention

L'invention a pour objet un procédé de dépôt d'un film monocristallin en accord de maille avec une première couche en alliage de silicium-germanium d'un substrat, le procédé étant facile à réaliser et permettant de former un film en alliage de silicium-germanium avec une rugosité de surface réduite.

On tend vers cet objet au moyen d'un procédé de croissance cristalline par épitaxie d'une couche cible monocristalline comportant successivement:
- fournir un substrat comportant une première couche monocristalline en alliage de silicium-germanium avec une première surface recouverte par un oxyde de protection obtenu par oxydation en voie humide de la première surface, la première surface possédant une température de dégradation dans laquelle la première surface forme des ilots,
- soumettre l'oxyde de protection à un traitement plasma pour former un sel fluoré puis supprimer le sel fluoré au moyen d'un recuit,
- introduire le substrat dans une chambre de procédé à une température de chargement inférieure à la température de dégradation,
- soumettre le substrat à une rampe en température depuis la température de chargement jusqu'à une température de recuit supérieure à la température de dégradation, formation d'une couche tampon lors de ces étapes par l'ajout de précurseur dans la chambre de procédé,
- recuire la première surface à une température supérieure ou égale à la température de recuit sous une atmosphère hydrogène ou azote, la chambre de procédé étant dépourvue de précurseur des matériaux formant la couche cible, de silicium et de germanium durant le recuit,
- déposer la couche cible monocristalline en accord de maille avec la première couche monocristalline par dépôt chimique en phase vapeur.

Dans un développement, l'épaisseur de la couche tampon est inférieure ou égale à 2nm.

Dans un mode de réalisation particulier, lors de la rampe en température, l'atmosphère dans la chambre de procédé est dépourvue de précurseur du germanium.

De manière avantageuse, la vitesse maximale de croissance de la couche tampon est inférieure à 2nm/min.

Préférentiellement, la température de chargement est inférieure à 500°C.

Il est avantageux de prévoir que la couche tampon possède une teneur continûment décroissante en germanium depuis l'interface avec la première couche monocristalline jusqu'à la couche cible.

Dans un mode de réalisation avantageux, la couche cible est choisie parmi un alliage de silicium germanium, un film de germanium pur, un matériau de type III-V.

Dans un autre développement, la première surface possède une teneur en germanium comprise entre 20% et 95% atomique.

Avantageusement, la couche tampon est en alliage de silicium-germanium dont la teneur en germanium est inférieure à 15% atomique et inférieure à la teneur en germanium de la première surface d'au moins 5% atomique ou la couche tampon est en germanium pur.

Préférentiellement, la température de dégradation étant supérieure ou égale à 550°C, le précurseur de silicium contient du dichlorosilane ou
la température de dégradation étant comprise entre 500°C et 600°C, le précurseur de silicium contient du silane, ou
la température de dégradation étant comprise entre 450°C et 550°C, le précurseur de silicium contient du disilane, ou
la température de dégradation étant inférieure à 500°C, le précurseur de silicium contient du trisilane et/ou du tétrasilane.

### Description sommaire des dessins

D'autres avantages et caractéristiques ressortiront plus clairement de la description qui va suivre de modes particuliers de réalisation et de mise en oeuvre de l'invention donnés à titre d'exemples non limitatifs et représentés aux dessins annexés, dans lesquels :
[Fig.1] : la figure 1 représente, de manière schématique, en coupe, une première étape d'un procédé de fabrication d'une structure microcristalline ;
[Fig.2] : la figure 2 représente, de manière schématique, en coupe, une deuxième étape d'un procédé de fabrication d'une structure microcristalline ;
[Fig.3] : la figure 3 représente, de manière schématique, en coupe, une troisième étape d'un procédé de fabrication d'une structure microcristalline ;
[Fig.4] : la figure 4 représente, de manière schématique, en coupe, une quatrième étape d'un procédé de fabrication d'une structure microcristalline ;
[Fig.5] : la figure 5 représente, de manière schématique, en coupe, une cinquième étape d'un procédé de fabrication d'une structure microcristalline ;
[Fig.6] : la figure 6 représente une mesure par microscopie par force atomique d'une couche de silicium-germanium déposée sur une couche en silicium-germanium avec un procédé de nettoyage et/ou de préparation selon l'art antérieur ;
[Fig.7] : la figure 7 représente une mesure par microscopie par force atomique d'une couche de silicium-germanium déposée sur une couche en silicium-germanium avec un autre procédé de nettoyage et/ou de préparation selon l'art antérieur ;
[Fig.8] : la figure 8 représente une mesure par microscopie par force atomique d'une couche de silicium-germanium déposée sur une couche en silicium-germanium avec un autre procédé de nettoyage et/ou de préparation selon l'art antérieur ;
[Fig.9] : la figure 9 représente une mesure par microscopie par force atomique d'une couche de silicium-germanium déposée sur une couche en silicium-germanium avec un autre procédé de nettoyage et/ou de préparation selon l'art antérieur ;
[Fig.10] : la figure 10 représente une mesure par microscopie par force atomique d'une couche de silicium-germanium déposée sur une couche en silicium-germanium avec un autre procédé de nettoyage et/ou de préparation selon l'art antérieur ;
[Fig.11] : la figure 11 représente une mesure par microscopie par force atomique d'une couche de silicium-germanium déposée sur une couche en silicium-germanium avec un procédé de nettoyage et de préparation selon l'invention,
[Fig.12] : la figure 12 représente un cliché de microscopie électronique en transmission d'un empilement obtenu conformément à un procédé selon l'invention,
[Fig.13] : la figure 13 représente un profil EDX un empilement obtenu conformément à un procédé selon l'invention.

### Description des modes de réalisation

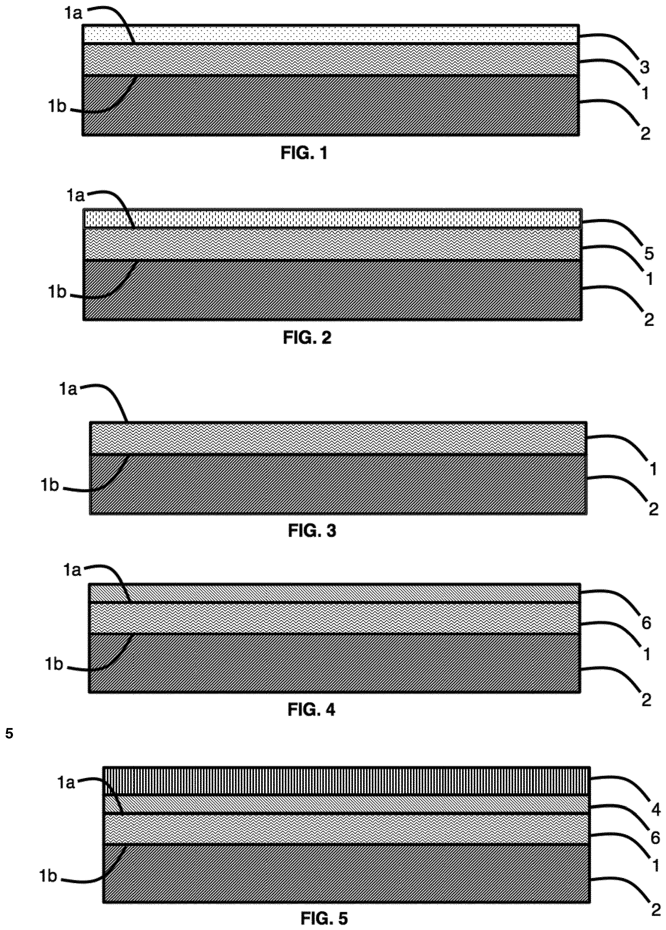

Comme illustré à la figure 1, un substrat est fourni qui comporte une première couche 1 monocristalline en alliage de silicium-germanium. La première couche 1 monocristalline est formée sur un support 2 qui est avantageusement monocristallin, par exemple un substrat en silicium monocristallin. La première couche 1 peut être contrainte, partiellement relaxée ou totalement relaxée de sorte que le paramètre de maille peut être en accord de maille ou en désaccord de maille avec le paramètre de maille du support 2. Le support peut également un être un substrat de type SOI pour (Semiconductor On Insulator)

La première couche 1 comporte avantageusement une teneur en germanium comprise entre 5% et 95% atomique et encore plus avantageusement entre 10% et 90% atomique afin de s'écarter du comportement d'un film de silicium pur ou de germanium pur. La première couche 1 en alliage de silicium-germanium peut avoir une teneur constante en germanium sur toute son épaisseur ou elle peut avoir une teneur variable.

La première couche 1 monocristalline peut recouvrir toute une face du substrat ou seulement une partie de la face du substrat. Il est possible que la face du substrat soit définie par la première couche 1 monocristalline et par un ou plusieurs autres matériaux par exemple électriquement isolants par exemple un oxyde de silicium ou un nitrure de silicium. La face du substrat comportant la première couche 1 peut être une face hétérogène et contenir au moins deux matériaux différents en surface dont la première couche 1.

La première couche 1 présente deux faces opposées avec une première face 1a qui est opposée à la face 1b en contact avec le support 2. La première couche 1 est recouverte par une couche de protection 3 qui est une couche d'oxyde obtenue par voie chimique, c'est-à-dire par oxydation par voie humide de la première surface de l'alliage.

Le procédé permet de déposer une couche cible 4 monocristalline en accord de maille avec une première couche 1 monocristalline en alliage de silicium-germanium. La couche cible 4 est de meilleure qualité qu'avec les procédés de l'art antérieur et la contamination d'interface sur la première face 1a est également très fortement réduite.

La couche cible 4 monocristalline peut être dans un matériau de type IV tel qu'en silicium, en alliage de silicium-germanium, en germanium pur ou alors dans un matériau de type III-V. Les matériaux de type III-V sont ceux dont les conditions de dépôt sont compatibles avec le budget thermique acceptable par la première couche 1 monocristalline en alliage de silicium-germanium.

A titre d'exemple, une couche en GaAs peut être déposée à environ 580°C ce qui la rend compatible avec une première couche 1 en alliage de silicium-germanium dont la teneur en germanium est sensiblement égale à 30% ou 40% atomique et qui peut supporter un recuit sous hydrogène au moins jusqu'à 650°C. En revanche, une couche de type GaN est déposée bien au-dessus de 650°C et n'est pas compatible avec la première couche 1. Les matériaux III-V envisagés sont choisis par exemple parmi GaAs, InP, InSb, AlAs et leurs mélanges.

La couche cible 4 peut être non-intentionnellement dopée, dopée avec du bore, dopée avec de l'arsenic ou avec du phosphore ou d'autres matériaux dopants électriques. Il est également envisageable d'introduire du carbone en position substitutionnelle ou interstitielle dans la maille cristalline.

Afin d'améliorer la qualité de la première surface 1a et notamment de réduire la contamination de première surface 1a, il est proposé d'appliquer une étape de nettoyage sur la première couche 1 monocristalline en alliage de silicium-germanium préalablement à l'épitaxie de la couche cible 4.

Dans un mode de réalisation particulier, la couche de protection 3 en oxyde obtenue par voie chimique est formée de la manière suivante.

La première couche 1 monocristalline est soumise à une étape de nettoyage qui comporte l'application d'une solution d'acide fluorhydrique, préférentiellement de l'acide fluorhydrique dilué dans l'eau déionisé pour retirer une éventuelle couche d'oxyde présente sur la surface ou des contaminants de type oxyde présents à la surface 1a de la première couche 1. La couche d'oxyde à enlever peut-être un oxyde natif, un oxyde thermique ou un oxyde déposé.

Une fois la première surface 1a de la première couche 1 désoxydée, cette dernière subit une étape d'oxydation de la première surface 1a par voie chimique, de préférence par voie humide, afin de former l'oxyde de protection 3. L'oxyde de protection 3 étant formé par voie chimique, il possède une composition différente d'un oxyde natif ou thermique obtenu depuis le même matériau. L'oxyde de protection 3 formé par voie chimique possède une composition chimique différente d'un oxyde formé par voie sèche tel qu'un oxyde natif, il va réagir différemment par la suite.

L'oxyde de protection 3 obtenu par voie chimique possède un comportement qui est plus proche d'un oxyde de silicium que d'un oxyde de silicium et germanium obtenu par oxydation native ou thermique de l'alliage.

L'oxydation par voie humide est avantageusement obtenue au moyen d'un bain oxydant.

Le bain oxydant contient par exemple une solution d'acide nitrique NH₄OH, d'eau oxygéné H₂O₂ et d'eau dé-ionisée HO₂. L'oxyde de protection 3 peut être obtenu au moyen d'une solution communément dénommée SC1 pour « Standard Cleaning 1 ». En alternative, la couche d'oxyde de protection 3 peut être formée par une solution contenant de l'eau dé-ionisée et de l'ozone O₃, par exemple avec une teneur en ozone comprise entre 5ppm et 20ppm. Une description détaillée des propriétés structurales de tels oxydes peut être trouvée dans la publication « Wet and Siconi Cleaning sequences for SiGe p-type métal oxide semiconductor channels » de P.E. RAYNAL et al. Microelectron. Eng., vol. 187-188, p. 84-89, Fev. 2018, pour des surfaces SiGe 40%. Les épaisseurs de ces oxydes chimiques sont alors typiquement dans la gamme 1.4 nm - 1.9 nm et ceux-ci sont, d'après la spectroscopie de photoélectrons XPS, quasiment voir totalement exempts de toutes traces de GeO₂ et de Carbone. L'épaisseur des oxydes de protection est avantageusement supérieure à 1 nm. Préférentiellement, l'épaisseur des oxydes de protection est inférieure à 5nm encore plus préférentiellement inférieure à 3nm. Il est avantageux de prévoir que l'oxyde de protection 3 contienne majoritairement en volume du SiO2.

L'utilisation d'une couche de protection 3 obtenue au moyen d'un procédé contrôlé permet de maitriser la contamination à la première surface 1a du substrat durant la période qui suit la formation de la couche de protection 3 et qui précède l'étape d'épitaxie. Les résultats sont plus répétables. La présence de l'oxyde chimique permet de protéger la première surface 1a des contaminants extérieurs.

La formation de la couche de protection 3 est avantageusement effectuée quelques dizaines de secondes après l'application du bain d'acide fluorhydrique, de préférence moins de 15 minutes après. Dans une alternative de réalisation, l'oxyde de protection est obtenu par voie thermique.

La couche de protection 3 est ensuite éliminée par un procédé en deux étapes qui consiste à transformer la couche de protection 3 en un sel fluoré 5 puis retirer le sel fluoré 5 au moyen d'un recuit.

Comme illustré à la figure 2, le substrat dont la surface est recouverte par la couche d'oxyde de protection 3 est soumis à un traitement plasma qui est configuré pour transformer la couche d'oxyde de protection 3 formée précédemment en un sel fluoré 5.

Le traitement plasma est un traitement plasma déporté c'est-à-dire que le substrat est soumis à une atmosphère contenant des ions. Les ions interagissent chimiquement avec la couche de protection 3 pour sa transformation et non pour son abrasion.

De préférence, la durée qui sépare la fin de l'étape de formation de la couche de protection 3 et le début du traitement plasma est inférieure à 15 minutes. Le début du traitement plasma peut être choisi comme le moment où le substrat se trouve à une pression inférieure ou égale à 5 Torr et éventuellement dans une atmosphère contenant majoritairement de l'argon.

De manière préférentielle, le traitement plasma est réalisé dans une enceinte ayant une atmosphère comportant au moins NH₃ et NF₃ simultanément ou consécutivement. L'atmosphère peut également contenir un autre gaz permettant de diluer les deux gaz précédents, par exemple un gaz choisi parmi H₂, He et Ar. Avantageusement, la pression dans l'enceinte est comprise entre 2 et 10 Torr, de préférence égale à 3 Torr.

Un enseignement relatif à la transformation de l'oxyde de protection 3 en un sel fluoré 5 est décrit dans le document US 8,501,629 ou dans le document US 2016/0192502. Un oxyde de protection SiO₂ est converti en sel fluoré (NH₄F)₂SiF₆ grâce à la réaction chimique suivante : NH₄F ou NH₄F.HF + SiO₂ -> (NH₄F)₂SiF₆ (solid) + H₂O donnée dans la publication « Advanced in situ pre-Ni silicide (Siconi) cleaning at 65nm to résolve defects in NiSix modules », de R. Yang et al., J. Vac. Sci. Technol. B Nanotechnol. Microelectron. Mater. Process. Meas. Phenom., vol. 28, n° 1, p. 56-61, janv. 2010. La formation du sel fluoré est obtenue avantageusement en utilisant une atmosphère qui contient NH₄F ou NH₄F.HF.

Comme illustré à la figure 3, à la suite du traitement plasma, la couche de protection 3 traitée plasma est soumise à un recuit afin d'éliminer le sel fluoré 5 par exemple au moyen de la réaction chimique suivante : (NH₄F)₂SiF₆ (solide)-> SiF₄ (gazeux) + 2NH₃ (gazeux) + 2HF (gazeux), comme cela est présenté dans la publication « Advanced in situ pre-Ni silicide (Siconi) cleaning at 65nm to résolve defects in NiSix modules », de R. Yang et al., J. Vac. Sci. Technol. B Nanotechnol. Microelectron. Mater. Process. Meas. Phenom., vol. 28, n° 1, p. 56-61, janv. 2010. Pour éliminer le sel fluoré 5, la température du substrat est avantageusement supérieure à 100°C et inférieure à 500°C et encore plus avantageusement comprise entre 100 et 200°C, préférentiellement égale à 180°C.

De manière avantageuse, le substrat est dépourvu de contact avec une atmosphère contenant de l'oxygène entre la formation du sel 5 et l'élimination du sel 5. De préférence, après la formation du sel 5, le substrat est en présence d'une ou plusieurs atmosphères qui ne contiennent qu'un ou plusieurs des gaz choisis parmi H₂, N₂, He, Ar.

L'utilisation de la couche de protection 3 obtenue par voie chimique en association avec le traitement plasma puis le retrait du sel 5 par un recuit a été testée sur une couche en silicium pur, en germanium pur et en alliage de silicium et de germanium. Il ressort que la valeur de la rugosité de surface est sensiblement la même avant et après traitement pour les trois matériaux testés. Il est également constaté que la surface est beaucoup plus pauvre en contaminant qu'avec un seul bain d'acide fluorhydrique. Il est alors possible de désoxyder la surface avant l'étape d'épitaxie sans introduire une quantité importante de contaminants. Des résultats représentatifs du gain procuré par la formation d'un oxyde chimique puis sa transformation en sel 5 et son élimination ont été présentées dans les publications « Advanced in situ pre-Ni silicide (Siconi) cleaning at 65nm to résolve defects in NiSix modules », de R. Yang et al., J. Vac. Sci. Technol. B Nanotechnol. Microelectron. Mater. Process. Meas. Phenom., vol. 28, n° 1, p. 56-61, janv. 2010 et « Wet and Siconi Cleaning sequences for SiGe p-type métal oxide semiconductor channels » de P.E. RAYNAL et al. Microelectron. Eng., vol. 187-188, p. 84-89, Fev. 2018.

Cette approche offrant de bons résultats relatifs à la contamination de surface, une couche cible 4 a été déposée afin de qualifier la qualité de l'interface et surtout la qualité de la couche cible 4. Il ressort que la couche cible 4 présente une rugosité de surface faible lorsqu'elle est déposée sur une première couche 1 en silicium pur et en germanium pur.

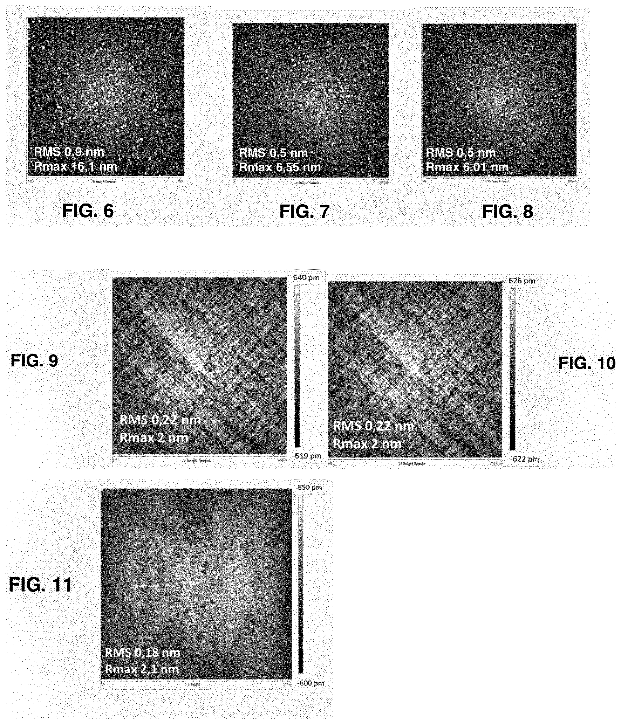

En revanche, il ressort que la qualité de la surface de la couche cible 4 déposée directement sur la première face 1a en alliage de silicium germanium n'est pas satisfaisante. Les inventeurs ont observé l'apparition d'ilots qui semblent se créer à l'interface entre la couche cible 4 et la première couche 1. La déformation de la surface provenant des ilots se reproduit dans l'épaisseur de la couche cible 4 de sorte que la couche cible 4 présente en surface une texturation sous la forme d'ilots disposés aléatoirement. Ces ilots sont illustrés aux figures 6, 7 et 8 représentatives de trois couches de protection différentes.

Afin de fournir une couche cible 4 ayant une meilleure qualité cristallographique, il est proposé le procédé d'épitaxie suivant pour le dépôt d'une couche cible 4 de meilleure qualité sur une première couche 1a en alliage de silicium-germanium.

Le substrat comporte la première couche 1 monocristalline en alliage de silicium-germanium avec sa première face 1a découverte. Le sel fluoré 5 a été éliminé précédemment et le substrat n'a pas été mis en présence d'oxygène depuis le retrait du sel 5.

Le substrat est introduit dans une chambre de procédé afin d'être mis en contact avec une atmosphère qui contient au moins un précurseur gazeux de la couche cible 4. Par exemple, l'atmosphère contient un précurseur du silicium et un précurseur du germanium pour réaliser le dépôt d'une couche cible 4 monocristalline en alliage de silicium-germanium.

La couche cible 4 est formée par dépôt chimique en phase vapeur. Lors du dépôt de la couche cible 4, la pression dans la chambre de procédé est avantageusement comprise entre 1 Torr et 760 Torr, 760 Torr représentant sensiblement la pression atmosphérique. De manière avantageuse, la pression lors du dépôt de la couche cible 4 est comprise entre 1 Torr et 100 Torr.

La formation de la couche cible 4 monocristalline par épitaxie ne pouvant être réalisée à température ambiante dans des conditions industrielles et/ou de qualités satisfaisantes, il est avantageux de soumettre le substrat à une rampe en température afin de pouvoir atteindre une gamme de température plus adaptée au dépôt de la couche cible 4. La rampe en température peut être une rampe linéaire, par paliers ou sous d'autres formes.

La gamme de température utilisée permet de déposer la couche cible 4 en accord de maille avec la première couche 1 monocristalline et avec des vitesses de dépôt et/ou des qualités cristallographiques compatibles avec une utilisation industrielle de la couche cible. L'augmentation de la température permet d'augmenter la vitesse de croissance de la couche cible 4 en comparaison de ce qui est accessible à la température de chargement.

Le substrat est donc introduit dans une chambre de procédé qui se trouve à une température de chargement. La chambre de procédé applique ensuite une rampe en température afin de faire évoluer la température du substrat depuis la température de chargement jusqu'à une température de recuit préalable au dépôt de la couche cible 4.

Durant la rampe, le substrat est avantageusement maintenu dans une gamme de pression comprise entre 1 Torr et 760 Torr. Le substrat se trouve dans une atmosphère qui contient majoritairement au moins un des gaz choisis parmi H₂, N₂, He et Ar. L'atmosphère est dépourvue d'oxygène. De préférence, l'atmosphère contient H₂, N₂, Ar, He, un mélange de ces derniers et est dépourvue d'un précurseur carboné et de précurseurs de dopants électriques de l'alliage et/ou de la couche cible.

Le substrat est disposé sur un suscepteur qui se trouve à la température de chargement ce qui va apporter de la chaleur au substrat. La température de chargement est adaptée selon le substrat afin que l'apport de chaleur ne détériore pas le substrat. Il est donc avantageux d'utiliser une température de chargement qui est comprise entre 350°C et 500°C. La température de chargement est choisie de manière à ne pas dégrader la première couche 1 en alliage de silicium-germanium et surtout la première surface 1a. La température de chargement est inférieure à la température de dégradation de la première surface 1a, c'est-à-dire inférieure à la température de formation des ilots sur la première surface 1a ou plus généralement de rugosification de la première surface 1. La température de dégradation est la température à partir de laquelle la première surface 1a rugosifie.

Par exemple, il est défini dans le domaine qu'une surface se rugosifie lorsque sur une image en microscopie par force atomique de la surface, la rugosité dite « Root Mean Square » RMS est supérieure ou égale à 1Â. Il est également possible de définir la rugosité toujours sur l'image en microscopie à force atomique par une différence entre une hauteur maximale hmxax et une hauteur minimale hmin du profile de rugosité qui est supérieure ou égale à 10Â (hmax-hmin).

Avant de déposer la couche cible 4, le substrat est maintenu quelques instants à une température de recuit choisie de manière à permettre une réorganisation des atomes formant la première surface de la première couche 1 pour améliorer la qualité cristallographique de la première surface 1a. Le recuit de réorganisation de la surface peut être réalisé à une température constante ou non.

La température de recuit est au moins égale à 500°C, de préférence au moins égale à 600°C et encore plus préférentiellement au moins égale à 620°C. La durée du recuit est de préférence au moins égale à 30 secondes. Plus la température du recuit est faible et plus la durée du recuit doit être importante. Un compromis doit être trouvé entre la durée du recuit et la température du recuit. Durant le recuit, l'atmosphère de la chambre est dépourvue d'un précurseur de la couche cible 4 afin d'éviter de déposer une couche qui bloquerait la réorganisation des atomes qui se trouvent à la surface formant l'interface avec l'atmosphère gazeuse ou qui figerait la surface détériorée.

Il a été observé que lors du recuit de réorganisation, la première surface 1a de l'alliage de silicium-germanium se réorganise et forme des ilots. Ces ilots sont de petites tailles et vont croitre avec la couche cible 4. II apparaît que la température de recuit appliquée pour réorganiser la surface préalablement à l'épitaxie est supérieure à la température de dégradation de la première surface 1a. Selon une autre interprétation, la réorganisation de la première surface 1a en alliage de silicium-germanium se traduit par l'apparition d'ilots.

Depuis l'élimination du sel 5 et jusqu'à l'introduction du substrat dans la chambre de procédé, le substrat est dépourvu de contact avec une atmosphère contenant de l'oxygène pour éviter de former un oxyde en surface. De manière avantageuse, le substrat est uniquement mis en contact d'atmosphères contenant exclusivement H₂, N₂, Ar, He ou un mélange de ces derniers. Les gaz utilisés sont préférentiellement ultra purs pour ne pas contaminer la surface sur laquelle l'épitaxie sera réalisée. La surface 1a est identique ou quasi identique à celle obtenue après l'élimination du sel 5.

Il a été observé que si lors de la rampe en température, l'atmosphère dans la chambre est dépourvue de précurseur de silicium, la qualité cristallographique de la couche cible 4 est non satisfaisante avec la présence d'ilots à la surface comme illustré aux figures 6 à 8. Au contraire, la présence d'un précurseur du silicium durant la rampe en température entre la température de chargement et la température de dépôt et plus particulièrement en dessous de la température de dégradation permet d'éviter, réduire ou retarder la formation des ilots avant de déposer la couche cible 4 (cf. figure 11). Il est possible d'évaluer la température de dégradation pour un substrat donné en appliquant des rampes à différentes températures maximales et en évaluant l'évolution de la rugosité de surface par microscopie à force atomique (AFM). La température de dégradation correspond à la température d'apparition des ilots pour une rampe en température donnée et un substrat donné.

L'ajout dans la chambre de procédé d'au moins un précurseur du silicium permet de recouvrir les atomes de l'alliage pour éviter la formation des ilots. L'ajout du précurseur du silicium durant la rampe en température permet de former une couche tampon 6 qui sépare la première couche 1 en alliage de silicium-germanium et la couche cible 4 comme illustré à la figure 4.

Comme illustré à la figure 5, la couche tampon 6 est déposée avant la couche cible 4. La couche tampon 6 sépare la couche cible 4 et la première couche 1.

La couche tampon 6 est formée dans un matériau qui supporte mieux le recuit de réorganisation. La couche tampon 6 est avantageusement formée en silicium pur, en germanium pur ou en alliage de silicium germanium dont la teneur en germanium est inférieure à 15% ou supérieure à 98% afin de se rapprocher du comportement du silicium pur ou du germanium pur. De préférence la teneur en germanium est inférieure à 10% atomique et encore plus préférentiellement inférieure à 5% atomique.

Lorsque la couche tampon 6 est formée dans un alliage de silicium-germanium dont la teneur en germanium est inférieure à 15% atomique, la teneur en germanium de la couche tampon 6 est préférentiellement inférieure à celle de la première couche 1 d'au moins 5% atomique.

Lorsque la couche tampon 6 est formée dans un alliage de silicium-germanium dont la teneur en germanium est supérieure à 98% atomique, la teneur en germanium de la couche tampon 6 est préférentiellement supérieure à celle de la première cible 1 d'au moins 5% atomique.

Durant la rampe, le précurseur du silicium est introduit dans la chambre à une température qui est inférieure à la température de dégradation de préférence au moins 50°C inférieure, par exemple inférieure à 520°C pour recouvrir la première surface avant que les atomes ne forment des ilots. Il est possible d'introduire le précurseur du silicium en dessous de 520°C et il est possible de maintenir le précurseur du silicium au-delà de 520°C.

Le précurseur du silicium est introduit durant la rampe en température à une température suffisamment faible pour former une fine couche tampon 6. La couche tampon 6 se dépose avec une vitesse de croissance faible.

De manière avantageuse, le ou les précurseurs de la couche tampon 6 sont introduits durant la rampe en température de manière à former une couche tampon dont l'épaisseur est inférieure ou égale à 2nm, préférentiellement inférieure ou égale à 1nm. Avantageusement, au moins trois plans atomiques sont déposés pour former la couche tampon 6. L'utilisation d'une telle gamme d'épaisseur permet de former une couche tampon 6 suffisamment épaisse pour empêcher la formation des ilots tout en étant suffisamment mince pour ne pas introduire des défauts cristallographiques ne pouvant être corrigés lors du recuit de réorganisation et ne pas perturber la connexion cristallographique entre la couche cible 4 et la première couche 1.

La couche tampon 6 est déposée à une température inférieure à la température de dégradation, c'est-à-dire à basse température et donc avec une vitesse de dépôt faible. Afin de conserver un temps dépôt réduit, il est particulièrement avantageux de déposer la couche tampon lors de l'évolution de la température du substrat, c'est-à-dire une augmentation de la température.

Afin de conserver un procédé intéressant industriellement, il est avantageux d'avoir une rampe en température inférieure à 5 minutes, encore plus préférentiellement inférieure à 3 minutes et avantageusement inférieure à 2 minutes.

Il est également avantageux d'avoir un procédé qui est utilisable sur une large gamme de premières couches 1 en alliage de silicium-germanium. Il est donc avantageux d'avoir une température de chargement plus basse que la gamme des températures de dégradation de la première couche qui est typiquement entre 500°C et 600°C. La température de dégradation sera d'autant plus faible que la concentration en germanium et l'épaisseur de la première couche sera élevée (sur un substrat en silicium ou se terminant par une couche de silicium).

Dans un cas de figure, le dépôt de la couche tampon 6 est initié à la température de chargement et il se poursuit jusqu'à la température de recuit. Dans une alternative de réalisation, le dépôt de la couche tampon 6 est initié à une température supérieure à la température de chargement et il se poursuit jusqu'à la température de recuit. Il est particulièrement avantageux de déposer la couche tampon jusqu'à la température de recuit afin de profiter des températures les plus importantes et donc des vitesses de croissance les plus élevées.

Pour éviter d'avoir une couche tampon 6 trop épaisse, il est possible de moduler la pression partielle des précurseurs de la couche tampon 6 pour moduler la vitesse de croissance. Il est également possible de choisir un précurseur du silicium qui possède une énergie d'activation importante, par exemple le dichlorosilane ou le trichlorosilane pour avoir une dépendance forte de la vitesse de croissance avec la température et ainsi limiter l'épaisseur de couche tampon 6 au début de la rampe et ne déposer la majorité de la couche tampon 6 que juste avant la température de dégradation et jusqu'à la température de recuit.

Il est possible de moduler la vitesse de montée en température lors de la rampe pour définir l'épaisseur de la couche tampon. La vitesse de montée en température ne peut pas être trop élevée car il faut maintenir la thermalisation du substrat. En revanche, une vitesse trop lente pénalise l'intérêt du procédé.

La rampe en température est utilisée pour thermaliser le substrat c'est-à-dire pour que la température du substrat égalise la température de consigne de la chambre. Il est donc particulièrement avantageux que la vitesse d'évolution de la température lors de la rampe en température ne soit pas trop forte ce qui se traduirait par une moins bonne maitrise de la vitesse de croissance. Il est avantageux d'avoir une vitesse d'évolution de la température dans la chambre comprise entre 1°C/s et 5°C/s.

Le dépôt de la couche tampon peut être arrêté lorsque l'épaisseur déposée atteint l'épaisseur seuil, par exemple 1 ou 2 nm.

La température de dépôt étant faible, les atomes n'ont pas tous l'énergie suffisante pour former une couche où les atomes sont parfaitement alignés. Il est donc particulièrement avantageux de choisir des conditions de dépôt pour lesquels la vitesse de dépôt est inférieure à 5 nm/min.

Afin de conserver un procédé de dépôt court, il est avantageux de limiter la durée de la rampe à 5 minutes, ou d'une manière plus générale la durée séparant l'introduction de la plaque dans la chambre et le début du dépôt de la couche cible 4 à moins de 5 minutes.

Lors de la montée en température, le substrat est soumis à une atmosphère qui contient au moins un précurseur du silicium. Il est également possible de prévoir que l'atmosphère contienne un précurseur du chlore. De manière avantageuse, l'atmosphère contient du dichlorosilane SiH₂Cl₂ qui est un précurseur du silicium et un précurseur du chlore. Il est particulièrement avantageux d'utiliser un précurseur qui est simultanément précurseur du silicium et précurseur du chlore. L'énergie d'activation étant importante, la dépendance de la vitesse de croissance avec la température est élevée ce qui permet de saturer la première surface 1a de l'alliage dès les basses températures tout en conservant une vitesse de croissance faible.

En alternative, le précurseur du silicium peut être un hydrure par exemple choisi parmi le silane SiH₄, le disilane Si₂H₆, le trisilane Si₃H₈ et le tétrasilane Si₄H₁₀.

L'utilisation d'une atmosphère contenant du chlore permet de déposer sélectivement la couche tampon 6 sur la première surface 1a et de ne pas déposer la couche tampon 6 sur les zones en matériau diélectrique. Dans un mode de réalisation particulier, il est possible de prévoir un premier précurseur du silicium formé par un hydrure et un deuxième précurseur du chlore formé par HCl gazeux.

Il est également possible de prévoir que le matériau de la couche tampon 6 soit un alliage de silicium germanium avec un précurseur du silicium tels que ceux présentés plus haut et un précurseur du germanium qui est avantageusement choisi parmi le germane GeH₄, le digermane Ge₂H₆ et le trigermane Ge₃H₈. Il est encore possible de prévoir l'apport d'un précurseur du chlore. Il est également possible d'utiliser du dichlorogermane.

L'utilisation d'un précurseur du silicium sous la forme d'un hydrure permet de déposer une couche tampon avec une vitesse plus importante qu'avec du dichlorosilane, les autres paramètres opératoires étant conservés.

Il est possible de choisir un précurseur de silicium particulier selon la température maximale de dépôt de la couche tampon 6 afin d'avoir une vitesse maximale de dépôt de la couche tampon 6 qui est faible et avantageusement comprise entre 0.5 et 5 nm/min.

Par exemple, si la température maximale de dépôt de la couche tampon 6 est supérieure à 600°C, l'atmosphère contient comme précurseur du silicium exclusivement ou quasi-exclusivement du dichlororilane ou du trichlorosilane.

Si la température maximale de dépôt de la couche tampon 6 est inférieure à 600°C et supérieure à 500°C, l'atmosphère contient comme précurseur du silicium exclusivement ou quasi-exclusivement du silane de préférence sans précurseur du chlore voire éventuellement du dichlorosilane.

Si la température maximale de dépôt de la couche tampon 6 est inférieure à 500°C et supérieure à 400°C, l'atmosphère contient comme précurseur du silicium exclusivement ou quasi-exclusivement du disilane de préférence sans précurseur du chlore.

Si la température maximale de dépôt de la couche tampon 6 est inférieure à 400°C, l'atmosphère contient comme précurseur du silicium exclusivement ou quasi-exclusivement du trisilane et/ou du tétrasilane.

Il a été observé que la fourniture d'une telle atmosphère lors de la phase de montée en température permet de recouvrir la première surface 1a d'une fine de silicium monocristallin en accord de maille avec la première couche 1 monocristalline. La fine couche de silicium encapsule la première couche 1 en alliage de silicium-germanium ce qui permet de rendre la première couche 1 moins sensible au budget thermique en ce qui concerne une augmentation de sa rugosité sous la forme d'ilots. Il en va de même pour une couche de germanium pur ou pour un alliage de silicium germanium cité plus haut qui possède un comportement proche du silicium pur ou du germanium pur avec néanmoins des conditions opératoires plus strictes.

A titre d'exemple, il a été observé que pour une première couche 1 monocristalline en alliage de silicium-germanium avec une teneur en germanium égale à 40% atomique et dont l'épaisseur est égale à 15 nanomètres, l'application d'une rampe en température jusqu'à 650°C se traduit par l'apparition d'ilots à la surface de la première couche 1. Les ilots son représentatifs d'une reconstruction de la surface. La surface de la première couche 1 étant très rugueuse, la deuxième couche déposée sur la première couche 1 sera naturellement de qualité médiocre, par exemple incompatible avec la formation d'un canal d'un transistor à effet de champ.

A titre d'exemple, avec une atmosphère constituée de dichlorosilane et d'hydrogène H₂ dans une enceinte dont la température est égale à 650°C et pour une pression égale à 20Torr, il est possible d'atteindre une vitesse de dépôt qui est sensiblement égale à 5Â/min. La vitesse de dépôt évoluant de manière exponentielle avec la température, il ressort que la vitesse de dépôt devient vite extrêmement faible lorsque la température diminue, les autres paramètres étant constants. Ainsi, lors de la rampe en température d'environ 500°C jusqu'à 650°C, il est possible de former une couche tampon 6 dont l'épaisseur est inférieure à 2nm et qui permet d'empêcher l'apparition des ilots sans allonger la durée de la rampe en température.

Dans un mode de réalisation, la température de dépôt de la couche cible 4 est égale à la température du recuit. Dans une autre configuration, la température du dépôt de la couche cible 4 est inférieure à la température du recuit. Par température du recuit, on entend avantageusement la température minimale entre l'arrêt du ou des précurseurs formant la couche tampon et l'injection du ou des précurseurs formant la couche cible 4. Il est également possible de considérer que la température du recuit est la température minimale ou moyenne entre la fin du dépôt de la couche tampon et le début du dépôt de la couche cible. Dans une alternative de réalisation, au moins un précurseur du silicium est également introduit dans la chambre de procédé lors du recuit.

De manière avantageuse, la vitesse moyenne de dépôt de la couche tampon 6 est inférieure à la vitesse moyenne de dépôt de la couche cible 4. Cette configuration permet de former une couche mince monocristalline dont les éventuels défauts cristallographiques peuvent être corrigés.

Lors du dépôt de la couche tampon 6, l'atmosphère contient un gaz vecteur qui est avantageusement de l'hydrogène. Il est également possible d'utiliser de l'azote. Lors du dépôt de la couche cible 4, l'atmosphère contient un gaz vecteur qui est avantageusement de l'hydrogène. Il est également possible d'utiliser de l'azote. Il est particulièrement avantageux d'utiliser le même gaz vecteur pour former la couche tampon 6 et la couche cible 4. Le gaz vecteur est un gaz dépourvu de silicium, de germanium, d'oxygène et de dopants électriques du silicium tels que le bore, l'arsenic et le phosphore. De manière générale, le gaz vecteur est un gaz qui ne permet pas de déposer un matériau à la surface de la première couche 1 et qui est dépourvu de dopant électrique. Préférentiellement, un seul gaz vecteur est utilisé depuis le chargement du substrat jusqu'à la fin du dépôt de la couche cible 4. Le gaz vecteur est avantageusement de l'hydrogène.

Il est particulièrement intéressant de maintenir une étape de recuit de réorganisation de préférence sous hydrogène et dépourvue d'oxygène et des précurseurs de la couche cible 4 afin de réorganiser la surface. Il a été observé qu'en l'absence de ce recuit de réorganisation la qualité de la couche cible 4 est moins bonne. Par exemple un dépôt continu de silicium depuis la température de chargement ne permet pas de former une couche de bonne qualité cristallographique.

Dans un mode de réalisation particulier, la température de chargement est inférieure à la température de dégradation d'au moins 50°C, de préférence d'au moins 75°C et encore plus préférentiellement d'au moins 100°C.

La première couche 1 étant en alliage de silicium-germanium, la température de recuit et plus généralement le budget thermique du recuit sont configurés pour éviter la détérioration de la première couche 1. Le budget thermique est configuré pour éviter le démouillage de la première couche 1 lorsque cette dernière est sur un film d'oxyde ou de nitrure tel qu'un oxyde de silicium ou un nitrure de silicium. Le budget thermique est configuré pour éviter le relâchement des contraintes dans la première couche 1 ce qui se traduit par la génération de dislocations. Le démouillage et la génération des dislocations sont supposés intervenir plus tard que la formation des ilots.

Il est donc avantageux de choisir une température de chargement qui est inférieure à la température de dégradation d'au moins 50°C, de préférence d'au moins 75°C et encore plus préférentiellement d'au moins 100°C.

Selon la même logique, pour avoir un procédé qui s'adapte à une grande diversité de première couche 1, la température d'injection du précurseur de silicium dans la chambre est inférieure à la température de dégradation d'au moins 50°C, de préférence d'au moins 75°C et encore plus préférentiellement d'au moins 100°C.

La température seuil de dégradation étant fonction du substrat et notamment de l'épaisseur de première couche 1 en alliage de silicium-germanium, de la composition de l'alliage, de la nature du support, il est préférable d'avoir une rampe de température sur au moins 50°C pour obtenir une couche tampon efficace pour des substrats variés.

Dans un mode de réalisation avantageux, la rampe en température, le recuit de réorganisation et le dépôt de la couche cible 4 sont réalisés avec un débit de gaz vecteur au moins égal à 1 sLm (c'est-à-dire 1 litre standard par minute). Le débit en gaz vecteur est avantageusement compris entre 1 sLm et 50 sLm, de préférence égal à 30 sLm. Le gaz vecteur est préférentiellement de l'hydrogène.

Il est également avantageux d'avoir un débit en précurseur de silicium compris entre 10 sccm (10 centimètre cubes standard par minute) et 1000 sccm. Il est avantageux d'utiliser un débit de dichlorosilane égal ou sensiblement égal à 360 sccm. Un débit identique peut être utilisé pour du silane. Il est avantageux d'utiliser un débit égal à 180 sccm pour du disilane Si₂H₆ ou un débit égal à 120 sccm pour du trisilane Si₃H₈. Il est encore possible d'utiliser un débit égal à 90 sccm pour du tétrasilane Si₄H₁₀.

Le procédé précité présente un intérêt plus particulièrement intéressant lorsque la première couche 1 en alliage de silicium-germanium comporte une première surface dont la teneur en germanium est comprise entre 20% et 95% atomique car il apparaît que dans cette gamme le comportement de l'alliage de silicium-germanium se distingue notablement du comportement d'un silicium pur et d'un germanium pur. Encore plus préférentiellement, la première surface présente une teneur en germanium comprise entre 25% et 90% atomique et encore plus préférentiellement entre 30% et 90% atomique.

Si la couche tampon est déposée de manière sélective, le procédé de dépôt de la couche tampon est dépourvu d'une alternance d'une première phase de dépôt en chimie hydrure suivie d'une deuxième phase de gravure en chimie chlorée. La première phase ayant pour but de déposer une première épaisseur de matériau et la deuxième phase ayant pour but de graver une partie de l'épaisseur déposée et surtout de graver les éventuels amas de matériaux qui se sont déposés sur les zones en matériaux électriquement isolants.

De manière avantageuse, la température minimale de dépôt de la couche cible 4 est supérieure à la température de dégradation de l'oxyde de protection 3 et supérieure à une température de réorganisation en surface de la première couche monocristalline en alliage de silicium-germanium 1. Par exemple, la couche cible 4 est déposée à une température supérieure à 650°C, voire supérieure à 700°C éventuellement supérieure à 800°C. De manière avantageuse, la température maximale de dépôt est inférieure à 1000°C, de préférence inférieure à 900°C.

Selon les modes de réalisation, l'épaisseur de la couche cible 4 peut varier entre quelques dizaines de nanomètres et plusieurs microns.

La première couche monocristalline en alliage de silicium-germanium 1 peut posséder une épaisseur inférieure à 50nm, préférentiellement inférieure à 20nm et encore plus préférentiellement inférieure à 10nm pour définir avantageusement un canal de conduction d'un transistor à effet de champ. La couche cible possède alors avantageusement une épaisseur inférieure à 100nm.

En alternative, la première couche monocristalline en alliage de silicium-germanium 1 peut posséder une épaisseur supérieure à 1micron pour définir un guide d'onde en alliage de silicium-germanium. Il est alors avantageux de recouvrir la couche en SiGe par une couche cible dont l'épaisseur est supérieure à un micron.

L'atmosphère gazeuse peut être dépourvue de précurseurs de dopants électriques ou au contraire elle peut contenir au moins un dopant électrique. Selon la même logique, l'atmosphère gazeuse peut être dépourvue ou contenir un précurseur du carbone pour former la couche cible 4.

Lors du dépôt de la couche cible 4, la température dans la chambre peut être constante ou elle peut évoluée sous la forme d'une ou plusieurs rampes.

De manière avantageuse, le dépôt de la couche cible 4 est effectué avec une vitesse de croissance au moins égale à 0.5 nm/min, avantageusement de plusieurs nm/min par exemple supérieur à 5nm/min, voire de plusieurs dizaines à centaines de nm/min selon l'épaisseur de la couche cible 4 à épitaxier par exemple comprise entre 20nm/min et 500nm/min.

Les figures 6, 7 et 8 représentent des images de la surface d'une couche cible 4 en alliage de silicium-germanium avec une teneur en germanium égale à 40% atomique. La rugosité de surface a été mesurée par un microscope à force atomique sur des surfaces de 10*10 µm². La couche cible 4 a été déposée directement sur la première surface 1a d'une première couche en alliage de silicium-germanium avec une teneur en germanium égale à 40%. Les figures 6, 7 et 8 se distinguent uniquement par les nettoyages et traitements réalisés avant l'introduction dans la chambre de procédé servant au dépôt de la couche cible 4.

La figure 6 correspond à un nettoyage sous bain d'acide fluorhydrique suivi par la formation d'un oxyde de protection 3 avec un bain oxydant de type SC1 puis avec transformation de l'oxyde de protection 3 en un sel fluoré 5 et élimination du sel fluoré 5. La couche cible 4 a été déposée sans couche tampon 6.

Le procédé utilisé pour la figure 7 se distingue de celui de la figure 6 par l'utilisation d'un bain oxydant de type SC1 à plus haute température. Le procédé utilisé pour la figure 8 se distingue de celui de la figure 6 par l'utilisation d'un bain oxydant comprenant de l'ozone.

Il ressort de ces trois images que l'absence de couche tampon 6 se traduit par la formation d'une surface granuleuse.

Les figures 9 et 10 représentent des images de la surface d'une couche cible en alliage de silicium-germanium avec une teneur en germanium égale à 40% atomique. La rugosité de surface a été mesurée par un microscope à force atomique sur des surfaces de 10*10 µm². La couche cible a été déposée directement sur la première surface 1a d'une première couche en alliage de silicium-germanium avec une teneur en germanium égale à 40% atomique dans les mêmes conditions que pour les figures 6, 7 et 8. La figure 9 correspond à une désoxydation simple de la surface avec un bain d'acide fluorhydrique ce qui correspond sensiblement à l'enseignement du document US 7,462,239. La figure 10 correspond à une désoxydation de la surface par transformation de l'oxyde présent en surface de la première couche en sel et élimination du sel.

Pour ces deux figures, on observe une structure en double tôle ondulée communément présentée sous la dénomination « cross hatch » représentative d'une relaxation plastique des contraintes emmagasinées.

La figure 11 représente une image de la surface d'une couche cible en alliage de silicium-germanium avec une teneur en germanium égale à 40% atomique. La rugosité de surface a été mesurée par un microscope à force atomique sur des surfaces de 10*10 µm². Le procédé utilisé correspond à celui décrit plus haut avec utilisation d'une couche tampon en silicium pur avec du dichlorosilane et d'un recuit sous hydrogène à une température de 650°C.

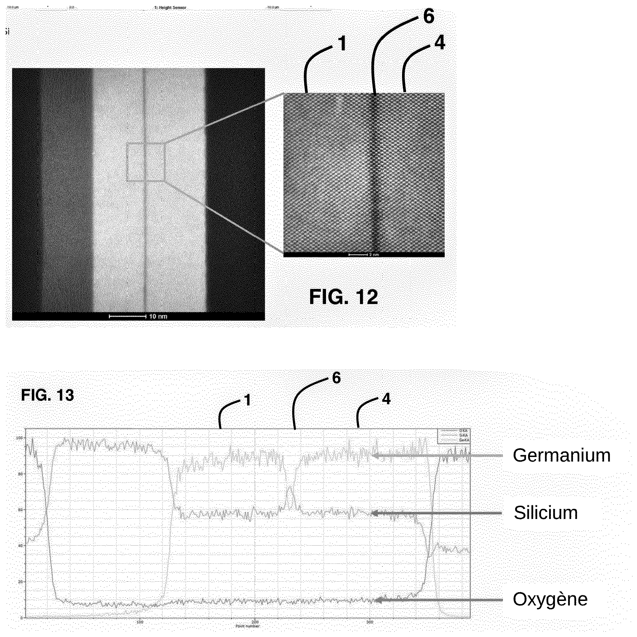

La figure 12 représente un cliché obtenu par microscopie électronique en transmission d'un empilement conforme à celui de la figure 11. La figure 13 représente un profil EDX des éléments Oxygène, Silicium et Germanium de l'empilement illustré à la figure 12. Le pic d'oxygène présent sur la partie gauche du profil représente une couche d'oxyde enterrée d'un substrat de type SOI.

Dans un mode de réalisation avantageux, la première couche 1a forme ou s'étend depuis un canal de conduction d'un transistor à effet de champ, par exemple de type MOS. Le transistor peut être de configuration planaire ou de configuration FinFET. Cependant, la problématique de reprise d'épitaxie à basse température depuis une surface en alliage de silicium-germanium peut être présente dans d'autres domaines, comme par exemple celui des guides d'onde SiGe dans le moyen infra-rouge qu'on voudra encapsuler par une couche de silicium.

## Revendications

1. Procédé de croissance cristalline par épitaxie d'une couche cible (4) monocristalline comportant successivement:
- fournir un substrat comportant une première couche (1) monocristalline en alliage de silicium-germanium avec une première surface (1a) recouverte par un oxyde de protection (3) obtenu par oxydation en voie humide de la première surface (1a) ou obtenu par voie thermique, la première surface (1a) possédant une température de dégradation dans laquelle la première surface (1a) forme des ilots,
- soumettre l'oxyde de protection (3) à un traitement plasma pour former un sel fluoré (5) puis supprimer le sel fluoré (5) au moyen d'un recuit,
- introduire le substrat dans une chambre de procédé à une température de chargement inférieure à la température de dégradation,
- soumettre le substrat à une rampe en température depuis la température de chargement jusqu'à une température de recuit supérieure à la température de dégradation,
- recuire la première surface (1a) à une température supérieure ou égale à la température de recuit sous une atmosphère hydrogène ou azote,
- déposer la couche cible (4) monocristalline en accord de maille avec la première couche (1) monocristalline par dépôt chimique en phase vapeur,
procédé **caractérisé en ce que** lors de la rampe en température et éventuellement lors du recuit, au moins un précurseur du silicium est introduit dans la chambre de procédé entre la température de chargement et la température de dégradation de manière à déposer une couche tampon (6) monocristalline en accord de maille avec la première couche (1) monocristalline, la couche tampon (6) monocristalline séparant la couche cible (4) monocristalline et la première couche (1) monocristalline.

2. Procédé selon la revendication 1 **caractérisé en ce que** lors de la rampe en température, l'atmosphère dans la chambre de procédé est dépourvue de précurseur du germanium.

3. Procédé selon l'une des revendications 1 et 2 dans lequel la chambre de procédé est dépourvue de précurseur des matériaux formant la couche cible (4) monocristalline, de silicium et de germanium durant le recuit.

4. Procédé selon l'une quelconque des revendications précédentes dans lequel l'épaisseur de la couche tampon (6) monocristalline est inférieure ou égale à 2nm.

5. Procédé selon l'une quelconque des revendications précédentes dans lequel la vitesse maximale de croissance de la couche tampon (6) monocristalline est inférieure à 2nm/min.

6. Procédé selon l'une quelconque des revendications précédentes dans lequel la température de chargement est inférieure à 500°C.

7. Procédé selon l'une quelconque des revendications précédentes dans lequel, la couche tampon (6) monocristalline possède une teneur continûment décroissante en germanium depuis l'interface avec la première couche (1) monocristalline jusqu'à la couche cible (4) monocristalline.

8. Procédé selon l'une quelconque des revendications précédentes dans lequel la couche cible (4) est choisie parmi un alliage de silicium germanium, un film de germanium pur, un matériau de type III-V.

9. Procédé selon l'une quelconque des revendications précédentes dans lequel la première surface (1a) possède une teneur en germanium comprise entre 20% et 95% atomique.

10. Procédé selon la revendication précédente dans lequel la couche tampon (6) monocristalline est en alliage de silicium-germanium dont la teneur en germanium est inférieure à 15% atomique et inférieure à la première teneur en germanium d'au moins 5% atomique ou dans lequel la couche tampon (6) monocristalline est en germanium pur.

11. Procédé selon l'une quelconque des revendications précédentes dans lequel, la température de dégradation étant supérieure ou égale à 550°C, le précurseur de silicium contient du dichlorosilane ou
dans lequel la température de dégradation étant comprise entre 500°C et 600°C, le précurseur de silicium contient du silane, ou
dans lequel la température de dégradation étant comprise entre 450°C et 550°C, le précurseur de silicium contient du disilane, ou
dans lequel la température de dégradation étant inférieure à 500°C, le précurseur de silicium contient du trisilane et/ou du tétrasilane.

## Patentansprüche

1. Verfahren zum Züchten einer monokristallinen Zielschicht (4) durch epitaktisches Wachstum, umfassend die folgenden aufeinanderfolgenden Schritte:
- Bereitstellen eines Substrats, umfassend eine erste monokristalline Schicht (1) aus einer Silizium-Germanium-Legierung mit einer ersten Oberfläche (1a), die mit einem Schutzoxid (3) bedeckt ist, das durch Nassoxidation der ersten Oberfläche (1a) oder auf thermischem Wege erhalten wird, wobei die erste Oberfläche (1a) eine Abbautemperatur hat, bei der die erste Oberfläche (1a) Inseln bildet,
- Unterziehen des Schutzoxids (3) einer Plasmabehandlung, um ein fluoriertes Salz (5) zu bilden, und anschließendes Beseitigen des fluorierten Salzes (5) durch Glühen,
- Einführen des Substrats in eine Prozesskammer bei einer Beschickungstemperatur, die kleiner als die Abbautemperatur ist,
- Unterziehen des Substrats einer Temperaturrampe von der Beschickungstemperatur bis zu einer Glühtemperatur, die größer als die Abbautemperatur ist,
- Glühen der ersten Oberfläche (1a) unter einer Wasserstoff- oder Stickstoffatmosphäre bei einer Temperatur, die größer oder gleich der Glühtemperatur ist,
- Abscheiden der zur ersten monokristallinen Schicht (1) gitterangepassten monokristallinen Zielschicht (4) durch chemische Abscheidung aus der Dampfphase,
wobei das Verfahren **dadurch gekennzeichnet ist, dass** während der Temperaturrampe und eventuell während des Glühens zwischen der Beschickungstemperatur und der Abbautemperatur mindestens eine Siliziumvorstufe in die Prozesskammer eingeleitet wird, um eine zur ersten monokristallinen Schicht (1) gitterangepasste monokristalline Pufferschicht (6) abzuscheiden, wobei die monokristalline Pufferschicht (6) die monokristalline Zielschicht (4) von der ersten monokristallinen Schicht (1) trennt.

2. Verfahren nach Anspruch 1, **dadurch gekennzeichnet, dass** die Atmosphäre in der Prozesskammer während der Temperaturrampe frei von einer Germaniumvorstufe ist.

3. Verfahren nach einem der Ansprüche 1 und 2, wobei die Prozesskammer während des Glühens frei von Vorstufen der die monokristalline Zielschicht (4) bildenden Materialien, Silizium und Germanium ist.

4. Verfahren nach einem der vorherigen Ansprüche, wobei die Dicke der monokristallinen Pufferschicht (6) kleiner oder gleich 2 nm ist.

5. Verfahren nach einem der vorherigen Ansprüche, wobei die maximale Wachstumsrate der monokristallinen Pufferschicht (6) kleiner als 2 nm/min ist.

6. Verfahren nach einem der vorherigen Ansprüche, wobei die Beschickungstemperatur kleiner als 500 °C ist.

7. Verfahren nach einem der vorherigen Ansprüche, wobei die monokristalline Pufferschicht (6) von der Grenzfläche mit der ersten monokristallinen Schicht (1) bis zur monokristallinen Zielschicht (4) einen kontinuierlich abnehmenden Germaniumgehalt aufweist.

8. Verfahren nach einem der vorherigen Ansprüche, wobei die Zielschicht (4) aus einer Silizium-Germanium-Legierung, einer reinen Germanium-Dünnschicht und einem III-V-Material gewählt ist.

9. Verfahren nach einem der vorherigen Ansprüche, wobei die erste Oberfläche (1a) einen Germaniumgehalt zwischen 20 und 95 Atom-% aufweist.

10. Verfahren nach dem vorherigen Anspruch, wobei die monokristalline Pufferschicht (6) eine Silizium-Germanium-Legierung ist, deren Germaniumgehalt kleiner als 15 Atom-% ist und mindestens um 5 Atom-% kleiner ist als der erste Germaniumgehalt, oder wobei die monokristalline Pufferschicht (6) aus reinem Germanium ist.

11. Verfahren nach einem der vorherigen Ansprüche, wobei die Siliziumvorstufe Dichlorsilan enthält, wenn die Abbautemperatur größer oder gleich 550 °C ist, oder wobei die Siliziumvorstufe Silan enthält, wenn die Abbautemperatur zwischen 500 °C und 600 °C liegt, oder wobei die Siliziumvorstufe Disilan enthält, wenn die Abbautemperatur zwischen 450 °C und 550 °C liegt, oder wobei die Siliziumvorstufe Trisilan und/oder Tetrasilan enthält, wenn die Abbautemperatur kleiner als 500 °C ist.

## Claims

1. Method for performing crystalline growth a monocrystalline target layer (4) by epitaxy successively comprising:
- providing a substrate comprising a first monocrystalline layer (1) made of silicon-germanium alloy with a first surface (1a) covered by a protective oxide (3) obtained by wet process oxidation of the first surface (1a) or obtained by thermal process, the first surface (1a) having a degradation temperature at which the first surface (1a) forms dots,
- subjecting the protective oxide (3) to plasma treatment to form a fluorinated salt (5) and then eliminating the fluorinated salt (5) by means of an anneal,
- inserting the substrate in a processing chamber at a loading temperature lower than the degradation temperature,
- subjecting the substrate to a temperature ramp from the loading temperature to an annealing temperature higher than the degradation temperature,
- annealing the first surface (1a) at a temperature higher than or equal to the annealing temperature in a hydrogen or nitrogen atmosphere,
- depositing the monocrystalline target layer (4) lattice matched with the first monocrystalline layer (1) by chemical vapor deposition,
method **characterised in that** during the temperature ramp and possibly when the anneal is performed, at least one silicon precursor is inserted in the processing chamber between the loading temperature and the degradation temperature so as to deposit a monocrystalline buffer layer (6) lattice matched with the monocrystalline first layer (1), the monocrystalline buffer layer (6) separating the monocrystalline target layer (4) and the monocrystalline first layer (1).

2. Method according to claim 1 **characterised in that** during the temperature ramp, the atmosphere in the processing chamber is devoid of any germanium precursor.

3. Method according to one of claims 1 and 2 wherein the processing chamber is devoid of a precursor of materials forming the monocrystalline target layer (4), of silicon and of germanium precursors during the anneal.

4. Method according to any one of the preceding claims wherein the thickness of the monocrystalline buffer layer (6) is less than or equal to 2nm.

5. Method according to any one of the preceding claims the maximum growth rate of the monocrystalline buffer layer (6) is less than 2nm/min.

6. Method according to any one of the preceding claims wherein the loading temperature is lower than 500°C.

7. Method according to any one of the preceding claims wherein the monocrystalline buffer layer (6) has a continually decreasing germanium content from the interface with the monocrystalline first layer (1) to the monocrystalline target layer (4).

8. Method according to any one of the preceding claims wherein the target layer (4) is chosen from a silicon-germanium alloy, a pure germanium film, or a material of III-V type.

9. Method according to any one of the preceding claims wherein the first surface (1a) has an atomic percentage germanium content comprised between 20% and 95%.

10. Method according to the preceding claim wherein the monocrystalline buffer layer (6) is made from silicon-germanium alloy with a germanium content of less than 15% atomic and lower than the first germanium content by at least 5% in atomic percent or wherein the monocrystalline buffer layer (6) is made from pure germanium.

11. Method according to any one of the preceding claims wherein the degradation temperature being greater than or equal to 550°C, the silicon precursor contains dichlorosilane or wherein the degradation temperature being comprised between 500°C and 600°C, the silicon precursor contains silane, or wherein the degradation temperature being comprised between 450°C and 550°C, the silicon precursor contains disilane, or wherein the degradation temperature being lower than 500°C, the silicon precursor contains trisilane and/or tetrasilane.
